# EUROPÄISCHE PATENTSCHRIFT

(11) **EP 0 392 636 B1**
(45) Veröffentlichungstag und Bekanntmachung des Hinweises auf die Patenterteilung: **14.08.1996**
(21) Anmeldenummer: 90200904.2
(22) Anmeldetag: 12.04.1990
(51) Int. Cl.: G06F 11/26, G01R 31/28

(54) **Integrierte Schaltungsanordnung**
Integrated circuit
Circuit intégré

(30) Priorität: 12.04.1989 DE 3911939
(43) Veröffentlichungstag der Anmeldung: 17.10.1990
(73) Patentinhaber: Philips Patentverwaltung GmbH, 22335 Hamburg (DE); Philips Electronics N.V., 5621 BA Eindhoven (NL)
(72) Erfinder: Edelin, Jean, F-78610 Le Perray en Yvelines (FR); Vagg, Andrew Derek, Shirley Southampton SO1 5EF (GB); Hapke, Friedrich, D-2000 Hamburg 61 (DE); Solbach, Rüdiger, D-2000 Hamburg 20 (DE); Stampe, Matthias, D-2000 Hamburg 65 (DE)
(74) Vertreter: Poddig, Dieter, Dipl.-Ing.

(56) Entgegenhaltungen:
- EP-A- 0 209 982
- GB-A- 2 085 171
- GB-A- 2 195 185
- 1988 IEEE INT. CONF. ON COMPUTER DESIGN: VLSI in Computers & Processors Oktober 1988, New York US Seiten 330 - 333; L. WHETSEL: "A Proposed Standard Test Bus and Boundary Scan Architecture"
- ELEKTRONIK. vol. 38, no. 9, 28 April 1989, MUNCHEN DE Seiten 108 - 113; J. MAIERHOFER et al.: "Der "JTAG Boundary-Scan""

## Beschreibung

Die Erfindung betrifft eine integrierte Schaltungsanordnung gemäß dem Oberbegriff des Patentanspruchs 1.

Integrierte Schaltungsanordnungen umfassen eine sehr große Anzahl von einzelnen Schaltungselementen, so daß die Prüfung einer derartigen Schaltungsanordnung äußerst schwierig ist. Um überhaupt eine Prüfung mit vertretbarem Aufwand durchuführen, wird die gesamte integrierte Schaltungsanordnung manchmal in mehrere digitale Schaltungsblöcke aufgeteilt, deren Prüfung einfacher ist. Es sind jedoch zusätzliche Schaltungen innerhalb der integrierten Schaltungsanordnung erforderlich, um zum einen die einzelnen Schaltungsblöcke unabhängig voneinander prüfen zu können und um den Ablauf der Prüfung zu steuern.

Aus der DE-OS 37 23 121 ist eine Prüfsteuerschaltung für eine integrierte Schaltungsanordnung mit mehreren Schaltungsblöcken bekannt, die jedoch eine größere Anzahl zusätzlicher externer Anschlüsse benötigt. Die Signale zumindest eines Teils dieser Anschlüsse werden decodiert, um daraus weitere Prüfsteuersignale zu erzeugen. Damit sind bei einer gegebenen Anzahl von Anschlüssen nur begrenzte Prüfungen möglich.

Aus der Zeitschrift "Elektronik", Heft 21 vom 14.10.1988, sind verschiedene Beiträge für den prüffreundlichen Entwurf von digitalen integrierten Schaltungen enthalten, wobei insbesondere in dem Aufsatz auf den Seiten 153 bis 158 ein Entwurfsverfahren bzw. ein Aufbau einer derartigen Schaltung beschrieben wird, bei dem die gesamte Schaltung in verschiedene Schaltungsmodule aufgeteilt wird. Ferner ist ein Steuerwerk für den Prüfablauf vorgesehen, über dessen Aufbau jedoch keine nähreren Angaben gemacht werden, und auch die Anzahl der für die Prüfung zusätzlich erforderlichen äußeren Anschlüsse ist nicht näher erwähnt. Ferner ist aus der EP-OS 265 913 eine integrierte Schaltungsanordnung mit einer Prüfsteuerschaltung bekannt, die nur zwei Abschlüsse aufweist. Für die vollständige Prüfung sind jedoch noch weitere Testanschlüsse erforderlich, und die Prüfsteuerschaltung erzeugt lediglich zwei verschiedene Folgen von jeweils zwei Prüfsteuersignalen, abhängig von den Signalen an den beiden Anschlüssen der Prüfsteuerschaltung, so daß damit auch nur eine geringe Prüfmöglichkeit besteht.

Aus 1988 IEEE INT. CONF. ON COMPUTER DESIGN: VLSI in Computers & Processors; Oktober 1988, New York, US; Seiten 330 - 333, ist eine Architektur von integrierten Schaltungen bekannt, über die eine Anzahl auf einem Träger bzw. einer Leiterplatte angeordnete integrierte Schaltungen sowohl gemeinsam mit den Verbindungen untereinander als auch für sich geprüft werden können. Dazu enthält jede integrierte Schaltung an den Eingangs- und Ausgangsanschlüssen sogenannte Boundary Scan Register sowie zwei zusätzliche Registerketten, nämlich ein Datenregister und ein Instruktionsregister, die von der Steuerschaltung über getrennte Eingänge eingeschrieben und ausgelesen werden können. Das Datenregister ist mit Boundary Scan Registern gekoppelt, und das Instruktionsregister erzeugt Adressen und und Steuersignale, um auf bestimmte Abtastwege in dem Datenregister zuzugreifen. Mit diesen zusätzlichen Schaltungsmitteln ist jedoch ein umfangreicher und vollständiger Test der eigentlichen Schaltung in der integrierten Schaltung nicht möglich und auch nicht beabsichtigt.

Aus der der GB 2 195 185 ist ferner eine Anordnung zum Test von integrierten Schaltungen bekannt, die ein Register enthält, das gesteuert eingeschrieben werden kann und von dem Steuersignale abgeleitet werden können. Es ist jedoch nicht näher angegeben, wie diese Steuersignale arbeiten.

Aufgabe der vorliegenden Anmeldung ist es, eine integrierte Schaltungsanordnung der eingangs genannten Art anzugeben, die mit einer geringen Anzahl von zusätzlichen Anschlüssen für die Prüfung und mit geringem Schaltungsaufwand eine umfassende Prüfung sehr unterschiedlich aufgebauter Schaltungsblöcke ermöglicht.

Diese Aufgabe wird durch die in den Ansprüchen angegebenen Maßnahmen gelöst. das Taktsignal von dem Signal eines ersten äußeren Anschlusses abgeleitet ist,
b) je Schieberegisterstufe außer der in der Reihe letzten Schieberegisterstufe wenigstens ein Speicherelement und eine Verknüpfungsstufe, die aus einer logischen Verknüpfung eines Ausgangssignals des Speicherelements bzw. der Speicherelemente dieser Schieberegisterstufe mit einem Ausgangssignal der in der Reihe letzten Schieberegisterstufe und mit einem Eingangssignal eines zweiten äußeren Anschlusses ein Prüfsteuersignal erzeugt.

Auf diese Weise können über eine geringe Anzahl zusätzlicher äußerer Anschlüsse durch entsprechende logische Verknüpfungen in den einzelnen Schieberegisterstufen eine große Anzahl unterschiedlicher Prüfsteuersignale zum Prüfen unterschiedlich aufgebauter Schaltungsblöcke oder auch getrennte Prüfsteuersignale für die getrennte Prüfung einzelner ähnlich aufgebauter Schaltungsblöcke erzeugt werden. Es wird damit eine äußerst flexible Prüfmöglichkeit geschaffen.

Häufig enthalten integrierte digitale Schaltungen mindestens ein internes Bussystem, mit dem die Ausgänge mehrerer Schaltungsblöcke verbunden sind. Zur getrennten Prüfung der einzelnen Schaltungsblöcke müssen die gegenseitigen Verbindungen dieser Schaltungsblöcke, die allgemein über diesen Bus erfolgen, aufgetrennt werden, damit dem zu prüfenden Schaltungsblock ein eindeutiges Signalmuster zugeführt werden kann und das von diesem Schaltungsblock erzeugte Ausgangssignalmuster eindeutig ausgewertet werden kann. Dafür müssen mindestens während der Prüfung eines Schaltungsblocks die auf den Bus führenden Ausgänge der anderen, momentan nicht geprüften Schaltungsblöcke abgeschaltet werden. Ferner werden den Eingängen und/oder Ausgängen mindestens eines Teils der Schaltungsblöcke mehrstufige Register vor- bzw. nachgeschaltet, wobei die einzelnen Registerstufen jedes Registers in Form eines Schieberegisters in Reihe geschaltet werden können, so daß ein Prüfmuster seriell zugeführt werden kann und das Ergebnis-Signalmuster seriell ausgelesen werden kann. In die so gebildete Schieberegisterkette sind allgemein auch die in dem betreffenden Schaltungsblock vorhandenen Speicherelemente aufgenommen. Auf diese Weise kann jeder Schaltungsblock quasi als kombinatorische Schaltung geprüft werden. Für das Einschreiben der Prüfmuster in die so gebildeten Schieberegisterketten bzw. für das Auslesen der Ergebnismuster aus diesen Schieberegisterketten ist ein Schiebetakt erforderlich, der über einen äußeren Anschluß zugeführt werden muß, wobei dieser äußere Anschluß mit dem zweiten äußeren Anschluß der Prüf-Steuerschaltung identisch sein kann. Auf diese Weise ist die Anzahl der für die Prüfung zusätzlich erforderlichen äußeren Anschlüsse verringert.

Um die Anzahl der für die Prüfung zusätzlich erforderlichen äußeren Anschlüsse weiter zu verringern, ist es nach einer Ausgestaltung der Erfindung zweckmäßig, daß dem seriellen Dateneingang des Schieberegisters ein Speicherelement vorgeschaltet ist, das bei jedem Übergang in der einen Richtung des Signals am zweiten äußeren Anschluß das Ausgangssignal wechselt. Auf diese Weise ist zum Zuführen der Daten für die Einstellung der Prüfsteuersignale für einen bestimmten Prüfschritt kein gesonderter Dateneingang erforderlich.

Eine Prüfung muß wie jeder andere Ablauf von einem definierten Anfangszustand ausgehen. Dies gilt selbstverständlich auch für das Schieberegister der Prüf-Steuerschaltung. Es ist nach einer weiteren Ausgestaltung der Erfindung daher zweckmäßig, daß eine weitere Verknüpfungsschaltung die Signale am ersten und zweiten äußeren Anschluß empfängt und bei einer vorgegebenen Signalkombination ein Rücksetzsignal für alle Speicherelemente des Schieberegisters und weitere Speicherelemente der Prüf-Steuerschaltung erzeugt. Auf diese Weise kann die Prüf-Steuerschaltung in einen definierten Anfangszustand gebracht werden, ohne die zu prüfenden Schaltungsanordnungen zu beeinflussen.

Für die Prüfung einzelner Schaltungsblöcke sind allgemein mehrere Prüfsteuersignale erforderlich. Um diese auf einfache Weise mit Hilfe des Schieberegisters erzeugen zu können, ist es nach einer weiteren Ausgestaltung der Erfindung zweckmäßig, daß mindestens eine Schieberegisterstufe zwei in Reihe geschaltete Speicherelemente enthält und daß die nachgeschaltete Verknüpfungsstufe mehrstufig ist und die Ausgangssignale der Speicherelemente getrennt mit den weiteren Signalen verknüpft. Dies vereinfacht teilweise auch das Einschreiben der erforderlichen Bitfolge in das Schieberegister.

Ausführungsbeispiele der Erfindung werden nachstehend anhand der Zeichnung näher erläutert. Es zeigen
- Fig. 1: ein Beispiel einer integrierten Schaltungsanordnung in Form eines Blockschaltbilds,
- Fig. 2: eine Ausführungsform einer erfindungsgemäßen Prüf-Steuerschaltung,
- Fig. 3 bis 7: Beispiele für den internen Aufbau der einzelnen Schieberegisterstufen,
- Fig. 8: ein Zeitdiagramm verschiedener Signale innerhalb der Prüf -Steuerschaltung,
- Fig. 9: ein Beispiel der gesteuerten Zusammenschaltung verschiedener Speicherstufen am Eingang oder Ausgang oder innerhalb eines Schaltungsblocks zu einer Schieberegisterkette.

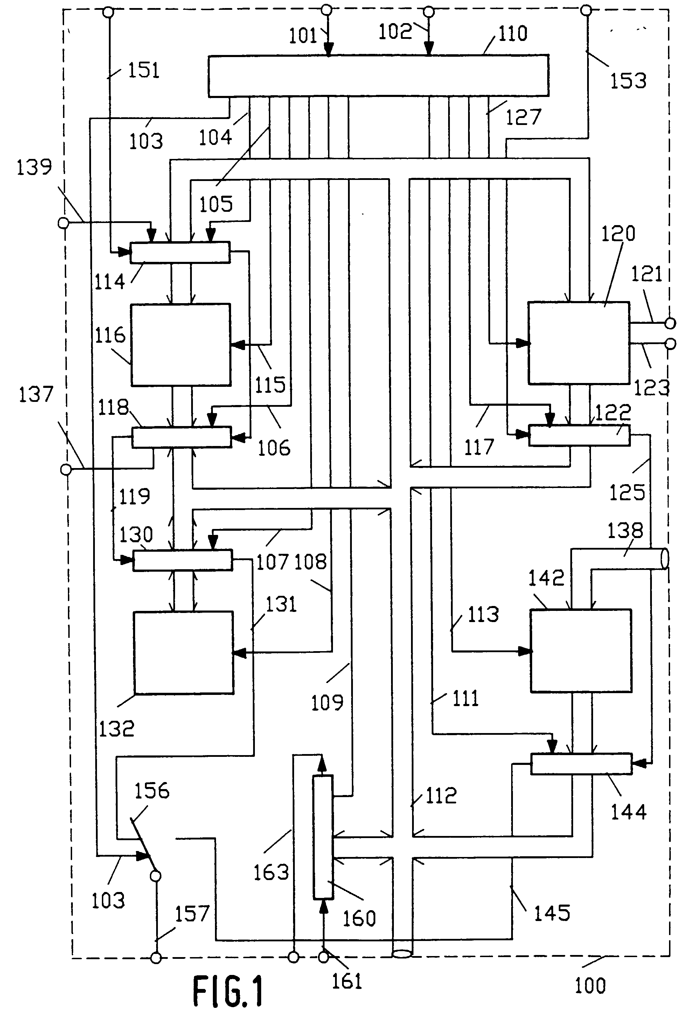

Die Fig. 1 zeigt ein Blockschaltbild als Beispiel einer Schaltungsanordnung, die auf einem Halbleiterplättchen 100 integriert ist. Sie enthält vier Schaltungsblöcke 116, 120, 132 und 142, die logische Verknüpfungsschaltungen in regelmäßiger Struktur (PAL, Decoder usw.), Verknüpfungsschaltungen in unregelmäßiger Struktur, ggf. in Verbindung mit Speicherelementen, oder Matrixspeicher enthalten können. Diese Schaltungsblöcke stehen untereinander in Verbindung über eine Anzahl Leitungen, die hier vereinfacht als ein allgemeiner Bus 112 dargestellt sind.

Die Eingänge des Schaltungsblocks 116 sind mit dem Bus 112 über eine Schaltung 114 verbunden, die hier als Block dargestellt ist und für jede Eingangsleitung eine Stufe enthält, die zumindest in einer bestimmten einstellbaren Betriebsweise speichernde Funktion haben. In einer anderen Betriebsweise können zumindest ein Teil der Stufen "transparent" sein, d.h. ein am Eingang anliegendes Signal wird unmittelbar zum Ausgang dieser Stufe übertragen. Alle Stufen der Schaltung 114 können außerdem in Form eines Schieberegisters in Reihe geschaltet werden. Die Einstellung dieser Betriebsweisen erfolgt über die hier vereinfacht als eine Leitung dargestellte Verbindung 104.

Wenn die Schaltung 114 als Schieberegister eingestellt ist, können über die Leitung 151 von außen Daten zugeführt und mit Hilfe eines nicht dargestellten Schiebetaktsignals durchgeschoben und am Ausgang 115 wieder abgegeben werden.

Der Schaltungsblock 116 kann auch Eingänge haben, die nicht mit dem Bus 112 verbunden sind, sondern denen direkt von außen Signale zugeführt werden, wie dem beispielsweise angedeuteten Eingang 139, der hier ebenfalls über die Schaltung 114 geführt ist, jedoch ohne weiteres auch direkt von außen auf den Schaltungsblock 116 führen kann.

Den Ausgängen des Schaltungsblocks 116 ist eine der Schaltung 114 entsprechende Schaltung 118 nachgeschaltet, die für jeden Ausgang eine Stufe enthält, die ggf. transparent und mit anderen als Schieberegister zusammengeschaltet werden kann. In diesem Zustand werden die vom Ausgang 115 der Schaltung 114 abgegebenen Signale durchgeschoben und am Ausgang 119 wieder abgegeben.

Die über die Schaltung 118 geführten Ausgänge des Schaltungsblocks sind in diesem Beispiel zumindest zum Teil mit dem Bus 112 verbunden, während ein beispielhaft dargestellter Ausgang 137 auch direkt nach außerhalb führen kann. Dieser Ausgang 137 kann auch direkt vom Schaltungsblock 116 nach außen geführt sein, ohne die Schaltung 118 zu durchlaufen.

Dem Schaltungsblock 132 ist eine Schaltung 130 zugeordnet, die im wesentlichen wie die Schaltungen 114 und 118 aufgebaut ist, jedoch bidirektional arbeitet und wahlweise dem Schaltungsblock 132 Signale vom Datenbus 112 zuführen oder Signale vom Schaltungsblock 132 dem Bus 112 zuführen kann. Auch die Schaltung 130 kann als Schieberegister eingestellt werden und überträgt dann die vom Block 118 über den Ausgang 119 zugeführten Signale zum Ausgang 131.

Der Schaltungsblock 120 ist mit seinen Eingängen direkt mit dem Bus 112 verbunden, wobei zusätzlich noch über die beispielhaft dargestellten Eingänge 121 und 123 Signale von außen zugeführt werden können, während den Ausgängen des Schaltungsblocks 120 eine Schaltung 122 nachgeschaltet ist, die insbesondere entsprechend der Schaltung 118 aufgebaut ist. Die in der Schaltung 122 enthaltenen Stufen können also wieder als Schieberegister geschaltet werden, wobei eine über den Eingang 153 zugeführte Signalfolge durchgeschoben und am Ausgang 125 abgegeben wird.

Die Eingänge des Schaltungsblocks 142 sind hier nicht mit dem Datenbus 112, sondern mit einer Anzahl von außen kommenden Datenleitungen 138 verbunden, während den Ausgängen des Schaltungsblocks 142 eine Schaltung 144 nachgeschaltet ist, die diese Ausgänge mit dem Bus 112 verbindet. Die Schaltung 144 ist im übrigen entsprechend der Schaltung 118 des Schaltungsblocks 116 aufgebaut. Der Ausgang 125 der Schaltung 122 ist mit dem seriellen Eingang der Schaltung 144 verbunden, deren serieller Ausgang 145 auf den einen Eingang eines Umschalters 156 führt, dessen anderer Eingang mit dem Ausgang 131 der Schaltung 130 verbunden ist. Dieser Umschalter 156 wird über die Verbindung 103 gesteuert.

Wie aus der Fig. 1 zu erkennen ist, bilden die Schaltungen 114, 118 und 130 ein langes Schieberegister, dem seriell über den Eingang 151 Daten zugeführt und in der einen Stellung des Umschalters 156 über den Ausgang 157 entnommen werden können. Entsprechend bilden die Schaltungen 122 und 144 ein Schieberegister, dem über den Eingang 153 seriell Daten zugeführt und in der anderen Stellung des Umschalters 156 über den Ausgang 157 entnommen werden können.

Wie außerdem der Fig. 1 entnommen werden kann, sind allen Schaltungsblöcken 116, 120, 132 und 142 zumindest am Ausgang Schaltungen nachgeschaltet, deren mit dem Bus 112 verbundener paralleler Ausgang hochohmig geschaltet werden kann, so daß sichergestellt werden kann, daß nur jeweils eine Datenquelle Signale auf den Bus 112 gibt.

An den Bus 112 ist ferner noch eine Bussteuerschaltung 160 angeschlossen, die im wesentlichen entsprechend der Schaltung 114 aufgebaut ist und der über den Eingang 161 seriell Daten zugeführt werden können, die in der Schaltung 160 durchgeschoben und am Ausgang 163 wieder abgenommen werden können. Außerdem können die in die Schaltung 160 eingeschobenen Daten parallel dem Bus 112 zugeführt oder die auf dem Bus 112 vorhandenen Daten parallel übernommen und seriell über den Ausgang 163 abgegeben werden.

Die Steuerung der den einzelnen Schaltungsblöcken zugeordneten Schaltungen 114, 118 usw. sowie der Bussteuerschaltung 160 und des Schalters 156 erfolgt durch eine Prüf-Steuerschaltung 110 über Verbindungen 103 bis 109, 111, 113, 117 und 127, die hier als einfache Verbindungen dargestellt sind, jedoch zumindest teilweise mehrere Leitungen umfassen können. Darüber werden außerdem die Schaltungsblöcke 116, 120, 132 und 142 in bestimmte Prüfzustände geschaltet.

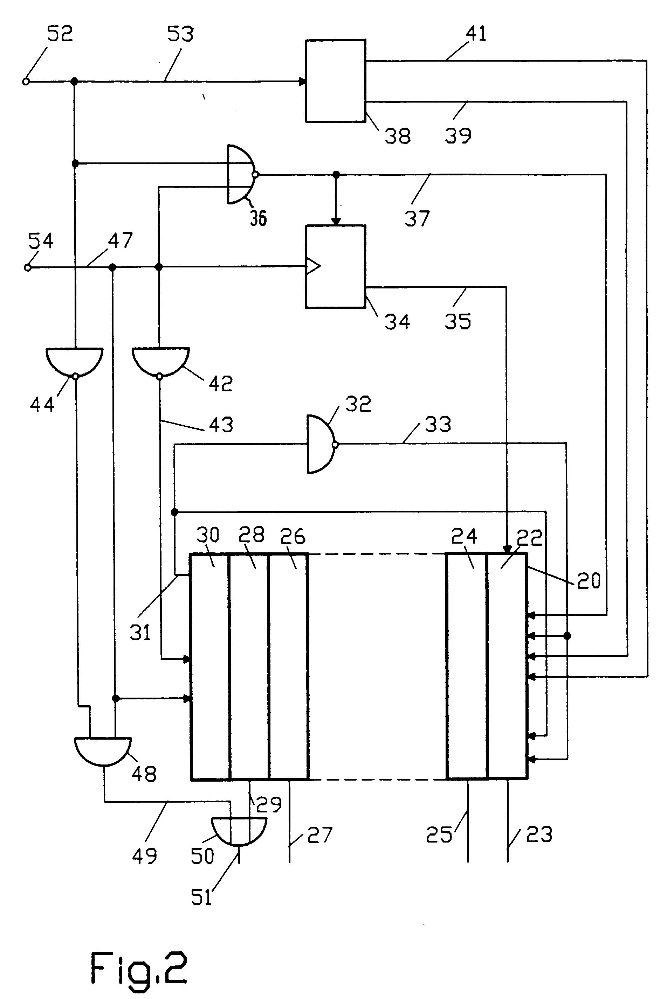

Zur Prüfung können nun über die Eingänge 151 und/oder 153 Datenfolgen zugeführt werden, die in den Schaltungen 114, und 130 Prüfsignalmuster für die zugehörigen Schaltungsblöcke darstellen, und die von den Schaltungsblöcken daraus gebildeten Ausgangssignale können über die den Ausgängen nachgeschalteten Schaltungen aufgenommen und seriell am Ausgang 157 abgegeben werden, um die Schaltungsblöcke einzeln oder in Kombination zu prüfen. Die dafür erforderlichen Prüfzustände der einzelnen Elemente werden nun durch die Ausgänge 103 bis 109 usw. der Prüf-Steuerschaltung 110 gesteuert, die in Fig. 2 dargestellt ist.

Danach enthält die Prüf-Steuerschaltung ein schematisch dargestelltes Schieberegister 20 aus einer Anzahl Stufen 22, 24, 26, 28 und 30, zwischen denen noch weitere Stufen vorhanden sein können. Jede der Stufen, die unterschiedlich aufgebaut sein können, wie später beispielhaft erläutert wird, erzeugt an dem entsprechenden Ausgang 23, 25, 27 bzw. 29 ein Signal, das eine bestimmte Funktion einiger Schaltungsteile der in Fig. 1 beispielhaft dargestellten Schaltung steuern.

Der Prüf-Steuerschaltung werden über die Eingänge 52 und 54 Signale zugeführt, wobei die dem Eingang 52 zugeführten Signale über die Leitung 53 u.a. einer Schaltung 38 zugeführt werden, die daraus zwei im wesentlichen komplementäre Taktsignale auf den Leitungen 39 und 41 erzeugt, die für einen bestimmten Aufbau der Stufen 22, 24 usw. des Schieberegisters 20 benötigt werden. Ferner führt die Leitung 53 auf ein NOR-Glied 36, von dem ein anderer Eingang mit einer Leitung 47 verbunden ist, die die Signale des Eingangs 54 weiterleitet. Wenn beide Eingänge 52 und 54 ein niedriges Signal erhalten, erzeugt das NOR-Glied 36 auf der Ausgangsleitung 37 ein Rücksetz-Signal, das alle Stufen des Schieberegisters 20 in einen definierten Anfangszustand setzt und außerdem ein Speicherelement 34 zurücksetzt. Dieses Speicherelement 34 wechselt mit jedem positiven Signalübergang auf der Leitung 47 den Signalzustand auf der Ausgangsleitung 35, die mit dem seriellen Dateneingang des Schieberegisters 20 verbunden ist.

Die Leitung 53 führt ferner über einen Inverter 44 auf den einen Eingang eines UND-Gliedes 48, von dem ein zweiter Eingang mit der Leitung 47 verbunden ist und dessen Ausgang mit dem einen Eingang eines ODER-Gliedes 50 verbunden ist, dessen anderer Eingang mit dem Ausgang 29 der Schieberegisterstufe 28 verbunden ist und dessen Ausgang 51 ein Signal erzeugt, das die in Fig. 1 dargestellte Schaltung in einen allgemeinen Prüfzustand bringt, wobei für die Durchführung irgendeiner Prüfung jedoch noch weitere Signale erforderlich sind.

Die Leitung 47 führt ferner direkt und außerdem über den Inverter 42 und über die Leitung 43 invertiert auf alle Stufen des Schieberegisters 20. Ferner führt der serielle Datenausgang 31 der letzten Stufe 30 des Schieberegisters 20 sowohl direkt als auch über einen Inverter 32 und eine Leitung 33 invertiert auf alle Stufen des Schieberegisters 20. Es wird ferner angenommen, daß das über den Eingang 54 der Leitung 47 zugeführte Signal zum seriellen Durchschieben der Daten durch die Schaltungen 114, 118 usw. in Fig. 1 dient.

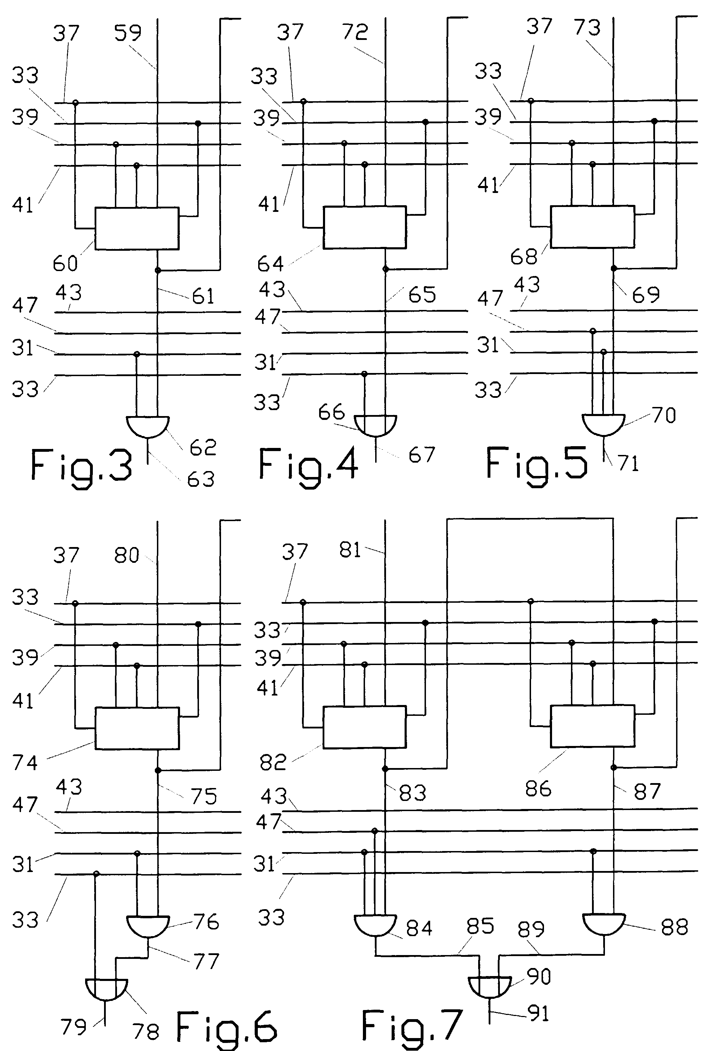

Die Fig. 3 bis 7 zeigen Möglichkeiten für den internen Aufbau der einzelnen Stufen 22, 24 usw. des Schieberegisters 20. Jede Stufe enthält ein bzw. zwei Speicherelemente, deren Zustand durch ein Eingangssignal in Verbindung mit Signalen auf den Leitungen 33, 37, 39 und 41 gesteuert werden, die den in Fig. 2 gleich bezeichneten Leitungen entsprechen. Das Ausgangssignal des Speicherelements bzw. der Speicherelemente wird in einer Verknüpfungsschaltung mit mindestens einem Signal von einer Anzahl Leitungen 31, 33, 43 und 47 verknüpft, die ebenfalls den in Fig. 2 gleich bezeichneten Leitungen entsprechen. Dabei führt also die Leitung 37 ein allgemeines Rücksetzsignal, die Leitung 33 stellt ein Freigabesignal für die Speicherelemente dar, und die Leitungen 39 und 41 führen Taktsignale für die Umschaltung des Speicherelements. Die Leitung 47 führt das dem Eingang 54 in Fig. 2 zugeführte Signal und die Leitung 43 das dazu invertierte Signal, während die Leitung 31 das serielle Ausgangssignal der letzten Schieberegisterstufe und die Leitung 33 die Invertierung davon führt. Die über die Leitung 35 dem seriellen Dateneingang des Schieberegisters 20 in Fig. 2 zugeführte Signalfolge wird so gewählt, daß sie stets mit einem hohen Signal beginnt, so daß auf der Leitung 31 ein hohes Signal und auf der Leitung 33 ein niedriges Signal erscheint, das das weitere Umschalten der Speicherelemente verhindert, wenn das Schieberegister 20 vollständig gefüllt worden ist entsprechend dem jeweiligen folgenden Prüfschritt bzw. Prüfschrittfolge. Nach deren Ende werden durch ein entsprechendes Signal auf der Leitung 37 alle Speicherelemente und damit auch das Speicherelement der letzten Stufe 30 des Schieberegisters 20 zurückgesetzt, und damit kann dieses erneut mit einem anderen Bitmuster für einen weiteren Prüfschritt gefüllt werden.

Bei dem in Fig. 3 dargestellten Aufbau wird der Zustand eines Speicherelements 60 mit Hilfe der Taktsignale auf den Leitungen 39 und 41 auf einen Zustand gesetzt, der durch das Signal auf dem Eingang 59 bestimmt ist. Dieser Eingang 59 erhält bei der ersten Stufe 22 das Signal von der Leitung 35 und bei den folgenden Stufen des Schieberegisters 20 jeweils vom Ausgang der vorhergehenden Stufe. Ein derartiger Ausgang wird bei der in Fig. 3 dargestellten Stufe durch den Ausgang 61 des Speicherelements 60 gebildet, der außerdem mit dem einen Eingang eines UND-Gliedes 62 verbunden ist, von dem ein weiterer Eingang mit der Leitung 31 verbunden ist, so daß an dessen Ausgang 63 ein Signal erscheint, wenn das Schieberegister 20 vollständig eingeschrieben ist und das Speicherelement 60 gesetzt ist.

Eine Stufe mit einem Aufbau gemäß Fig. 3 ist in dem Schieberegister 20 fast immer mehrfach vorhanden, wobei eine Stufe beispielsweise das Signal erzeugt, um die Bussteuerschaltung 160 zu aktivieren, eine andere Stufe das Signal, um alle Eingänge und Ausgänge eines zu prüfenden Schaltungsblocks zu aktivieren, eine weitere Stufe das Signal, um in einem entsprechend aufgebauten Schaltungsblock einen Selbsttest auszulösen, eine weitere Stufe, um einen funktionalen Test eines Schaltungsblocks auszuführen sowie die Stufe 28, deren Ausgangssignal über das ODER-Glied 50 die Schaltungsblöcke in einen internen Prüfzustand einstellt. Es sind noch weitere Prüfsteuersignale denkbar, die hier der Obersichtlichkeit halber nicht weiter aufgeführt sind.

Bei dem in Fig. 4 dargestellten Aufbau wird ein Speicherelement 64 auf einen über den Eingang 72 zugeführten Signalzustand eingestellt, und der Ausgang 65 des Speicherelements 64 führt auf die folgende Stufe sowie über ein ODER-Glied 66 auf einen Ausgang 67, wobei ein weiterer Eingang des ODER-Gliedes 66 mit der Leitung 33 verbunden ist. Dies bedeutet, daß am Ausgang 67 ein hohes Signal erzeugt wird, wenn sich die gesamte in Fig. 1 dargestellte Schaltung nicht im Testbetrieb, sondern im Betrieb für eine gewünschte Anwendung befindet, denn dann sind alle Schieberegisterstufen zurückgesetzt, oder wenn im Testbetrieb das Speicherelement 64 gesetzt ist. Dieses Signal kann insbesondere dazu dienen, in den Schaltungen 114, 118 usw. in Fig. 1 die für den transparenten Zustand vorgesehenen Stufen in diesen Zustand zu setzen.

Bei dem in Fig. 5 dargestellten Aufbau wird ein Speicherelement 68 auf einen Zustand entsprechend dem Signal am Eingang 73 gesetzt, und der Ausgang 69 des Speicherelements 68 führt außer auf die nächste Schieberegisterstufe auf einen Eingang eines UND-Gliedes 70, von dem ein weiterer Eingang mit der Leitung 31 und ein dritter Eingang mit der Leitung 47 verbunden ist. Dadurch erscheint am Ausgang 71 das dem Eingang 54 in Fig. 2 zugeführte Signal, wenn das Speicherelement 68 gesetzt und das Schieberegister 20 vollständig gefüllt ist. Dieses Signal kann beispielsweise den Schalter 156 in Fig. 1 steuern, so daß über das Signal auf der Leitung 47 also eine bestimmte Kette von Schaltungen, beispielsweise der Schaltungen 114, 118 und 130, ausgewählt werden kann.

Bei dem in Fig. 6 dargestellten Aufbau wird ein Speicherelement 74 auf einen Zustand eingestellt, der durch das Signal an einem Eingang 80 bestimmt wird. Das Signal am Ausgang 75 des Speicherelements 74 führt auf einen Eingang eines UND-Gliedes 76, von dem ein weiterer Eingang mit der Leitung 43 verbunden ist und der Ausgang 77 auf einen Eingang eines ODER-Gliedes 78 führt, von dem ein zweiter Eingang mit der Leitung 33 verbunden ist. Dadurch erscheint am Ausgang 79 das zu dem Signal am Eingang 54 inverse Signal, wenn das Speicherelement 74 gesetzt ist und das Schieberegister 20 vollständig gefüllt ist, während ansonsten, insbesondere außerhalb des Testbetriebes, ständig ein hohes Signal am Ausgang 79 erscheint. Diese Stufe ist allgemein ebenfalls mehrfach vorhanden, nämlich für jeden Schaltungsblock einmal, und schaltet die dessen Ausgängen nachgeordnete Schaltung durchlässig, so daß die Ausgangssignale des betreffenden Schaltungsblocks auf den Bus 112 in Fig. 1 gelangen.

Bei dem in Fig. 7 dargestellten Aufbau sind zwei Speicherelemente 82 und 86 in Reihe geschaltet, so daß sie in einen Zustand geschaltet werden, der durch zwei aufeinanderfolgende, einem Eingang 81 zugeführte Bits bestimmt wird. Der Ausgang 83 des Speicherelements 82 ist mit einem Eingang eines UND-Gliedes 84 verbunden, von dem ein zweiter Eingang mit der Leitung 47 und ein dritter Eingang mit der Leitung 31 und ein Ausgang 85 mit einem Eingang eines ODER-Gliedes 90 verbunden ist. Der Ausgang 87 des anderen Speicherelements 86 ist mit einem Eingang eines UND-Gliedes 88 verbunden, von dem ein anderer Eingang mit der Leitung 31 und der Ausgang 89 mit einem zweiten Eingang des ODER-Gliedes 90 verbunden ist. Das am Ausgang 91 erscheinende Signal dient vorzugsweise dazu, eine Kette von Schaltungen 114, 118 usw., die zu einem Taktsystem gehören, in den Schiebezustand zu schalten.

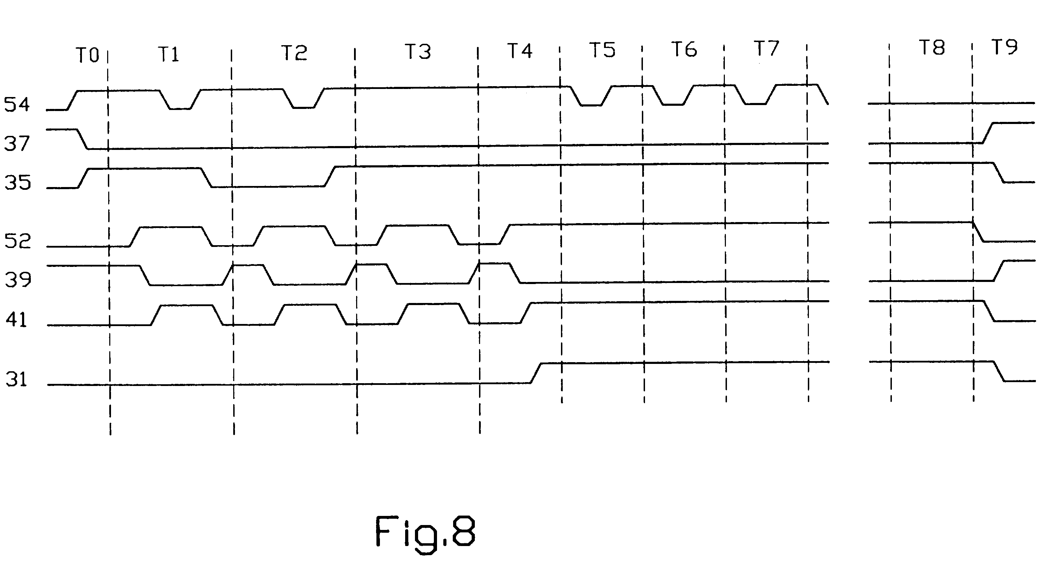

Die Fig. 8 zeigt ein Zeitdiagramm einiger Funktionsabläufe in der Prüf-Steuerschaltung nach Fig. 2. Die in Fig. 8 dargestellten einzelnen Signalverläufe sind mit Nummern bezeichnet, die den Leitungen bzw. Anschlüssen in Fig. 2 entsprechen, auf denen diese Signalverläufe auftreten.

Zunächst sind die Signale an beiden Anschlüssen 52 und 54 niedrig, so daß das Rücksetzsignal auf der Leitung 37 aktiv ist und alle Speicherelemente im Ruhezustand eingestellt hält. Im Abschnitt T0 wird nun das Signal am Anschluß 54 hoch, wodurch das Rücksetzsignal auf der Leitung 37 niedrig wird und gleichzeitig bzw. mit einer kleinen Zeitverzögerung, deren Erzeugung in Fig. 2 nicht näher dargestellt ist, das Speicherelement 34 umgeschaltet und das Signal auf der Leitung 35 hoch wird.

Im Zeitabschnitt T1 wird nun auch das Signal am Anschluß 52 hoch, wodurch die Taktsignale auf den Leitungen 39 und 41 ihren Zustand wechseln und den auf der Leitung 35 vorhandenen hohen Signalwert in das Schieberegister 20 einschreiben. Danach wird das Signal am Eingang 54 niedrig und danach wieder hoch, und bei diesem letzteren Signalübergang wird das Speicherelement 34 wieder umgeschaltet. Außerdem wird das Signal am Anschluß 52 niedrig, wodurch die Taktsignale auf den Leitungen 39 und 41 sich ebenfalls ändern. Dadurch werden die Speicherelemente im Schieberegister 20 zur Aufnahme der nächsten Daten vorbereitet.

Im Zeitabschnitt T2 geht das Signal am Eingang 52 wieder hoch, wodurch nun das niedrige Signal auf der Leitung 35 in das Schieberegister 20 eingeschrieben wird. Danach erfolgt wieder ein Signalwechsel am Anschluß 54, wodurch das Speicherelement 34 wieder umgeschaltet und das Signal auf der Leitung 35 hoch wird. Dieses hohe Signal wird in den Zeitabschnitten T3 und T4 zweimal in das Schieberegister 20 eingeschrieben. Wenn vereinfacht angenommen wird, daß das Schieberegister 20 nur vier Stufen aufweist, erscheint das am Anfang in das Schieberegister 20 eingeschriebene hohe Signal im Zeitabschnitt T4 am Ausgang 31, wodurch ein weiteres Einschreiben verhindert wird. Damit sind gleichzeitig alle dem Signalmuster auf der Leitung 35 entsprechenden Prüfsteuersignale am Ausgang des Schieberegisters 20 aktiv, und ein Prüfschritt bzw. eine Folge von Prüfschritten kann ausgeführt werden.

Dabei erfolgen beispielsweise in den Zeitabschnitten T5, T6 und T7 mehrere Signalwechsel am Eingang 54, die nun vorzugsweise als Schiebetakte für die Schaltungen 114, 118 usw. wirken, wobei diese Schaltungen durch entsprechende Prüfsteuersignale als Schieberegister geschaltet sind, um diese Schaltungen zu prüfen oder um in einem anderen Prüfabschnitt, wobei weitere Prüfsteuersignale andere Signalwerte haben, den zu prüfenden Schaltungsblöcken 116 usw. Signalmuster zuzuführen oder von diesen Schaltungsblöcken erzeugte Signalmuster aufzunehmen und seriell zum Ausgang 157 zu leiten.

Statt dessen kann im Anschluß an den Zeitabschnitt T4 auch ein anderer Prüfabschnitt folgen, der beispielsweise einen Selbsttest eines Schaltungsblocks umfaßt, wie im Zeitabschnitt T8 angedeutet ist, wobei die Signale an den Eingängen 52 und 54 konstant sind. Dies wird dadurch bestimmt, daß während der Zeitabschnitte T1 bis T4 der Signalverlauf am Eingang 54 anders ist, wodurch auf der Leitung 35 auch ein anderes Signalmuster entsteht und damit das Schieberegister 20 bzw. die Speicherelemente darin mit anderen Signalwerten eingeschrieben werden, die entsprechend andere Kombinationen von Prüfsteuersignalen erzeugen.

Es sei bemerkt, daß in den Zeitabschnitten T1 bis T8 stets mindestens einer der Signalanschlüsse 52 und 54 ein hohes Signal erhält, so daß das Rücksetzsignal auf der Leitung 37 inaktiv bleibt.

Am Ende jeweils eines Prüfschrittes bzw. einer zusammenhängenden Folge von Prüfschritten werden nun die Signale an beiden Eingängen 52 und 54 niedrig, d.h. im dargestellten Beispiel ist im Abschnitt T9 das Signal am Eingang 54 bereits niedrig und das Signal am Eingang 52 wird niedrig, wodurch nunmehr das Rücksetzsignal auf der Leitung 37 wieder aktiv wird und das Schieberegister 20 und das Speicherelement 34 zurücksetzt. Dadurch gehen die Signale auf den Leitungen 31 und 35 ebenfalls nach niedrig. Sofern die Prüfung nun nicht beendet ist, kann sich die Einstellung eines neuen Prüfschritts anschließen, wobei die in den Zeitabschnitten T0 bis T4 dargestellten Signalabläufe entsprechend wieder auftreten.

Mit der beschriebenen Prüf-Steuerschaltung ist es also möglich, über nur zwei Eingänge beliebige Kombinationen von Prüfsteuersignalen zu erzeugen, so daß eine sehr flexible Prüfung der unterschiedlichsten Schaltungsblöcke möglich ist.

Häufig sind die in z.B. den hier getrennt dargestellten Schaltungen 114 und 118 vorhandenen Stufen tatsächlich zumindest zum Teil Bestandteile des Schaltungsblocks 116 und bilden tatsächlich eine Einheit mit diesem. Dies ändert nicht die Steuerung der Prüfung des Schaltungsblocks 116 insgesamt, jedoch ist dann nicht der Bus 112 nicht ohne weiteres eingangsmäßig über die Schaltung 114 und ausgangsseitig über die Schaltung 118 zugänglich, so daß der Bus 112 nicht ohne weiteres über diese Schaltungen prüfbar ist. Hierfür ist dann die Bussteuerschaltung 160 in Fig. 1 vorgesehen.

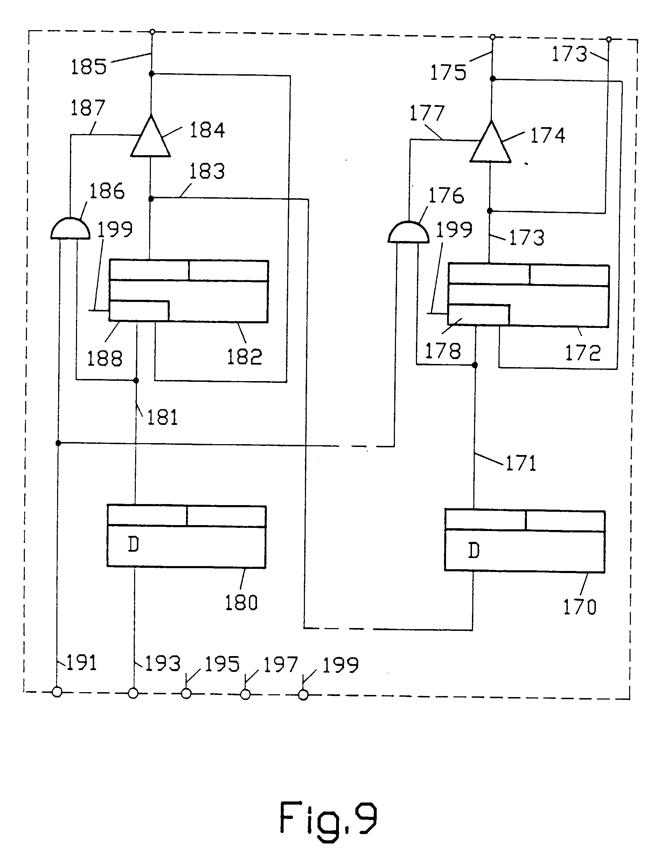

Ein möglicher Aufbau der Bussteuerschaltung 160 in Fig. 1, der mit gewissen Änderungen auch für die Schaltungen 114, 118 usw. verwendet werden kann, ist in Fig. 9 dargestellt. Für jede Busleitung ist ein Speicherelement vorgesehen, von denen in Fig. 9 nur zwei Speicherelemente 172 und 182 dargestellt sind. Der Ausgang 173 bzw. 183 dieses Speicherelements ist über eine Treiberstufe 174 bzw. 178 über den Ausgang 175 bzw. 185 mit der betreffenden Busleitung verbunden. Die Treiberstufe 174 bzw. 184 wird über die Leitung 177 bzw. 187 durch das Ausgangssignal eines UND-Gliedes 176 bzw. 186 in einen niederohmigen Zustand, in dem das Ausgangssignal des zugehörigen Speicherelements niederohmig übertragen wird, oder in einen hochohmigen Ausgangszustand gesteuert.

Jedes Speicherelement 172 bzw. 182 weist eine Eingangsschaltung 178 bzw. 188 für zwei Eingangssignale auf, die abhängig von dem Signal auf einer gemeinsamen, von außen zugeführten Leitung 199 einen dieser beiden Eingänge auswählt.

Ein Eingang aller UND-Glieder 176 bzw. 186 ist mit einer gemeinsamen, von außen zugeführten Leitung 191 verbunden, und ein zweiter Eingang ist mit einem Ausgang 171 bzw. 181 eines zugehörigen weiteren Speicherelements 170 bzw. 180 verbunden, wobei dieser Ausgang ferner auf einen Eingang der Eingangsschaltung 178 bzw. 188 des Speicherelements 172 bzw. 182 führt. Der andere Eingang dieser Eingangsschaltung ist mit dem Ausgang 175 bzw. 185 der zugehörigen Treiberstufe 174 bzw. 184 und damit mit der betreffenden Busleitung verbunden.

Die Speicherelemente 170 bzw. 180 entsprechen funktionell D-Flipflops, wobei der D-Eingang des Speicherelements 180 mit einer von außen kommenden Leitung 193 und die entsprechenden Eingänge der übrigen Speicherelemente wie des Speicherelements 170 mit dem Ausgang des ersten Speicherelements der jeweils vorhergehenden Stufe verbunden sind. Ferner sind noch zwei weitere Leitungen 195 und 197 für von außen kommende Taktsignale für alle Speicherelemente gemeinsam vorhanden, deren Verbindung mit den Speicherelementen der Übersichtlichkeit halber in Fig. 9 weggelassen ist.

Bei einem niedrigen Signal auf der Leitung 191 sind alle Treiberstufen 174 bzw. 184 gesperrt, und bei einem entsprechenden Signal auf der Leitung 199 werden die Ausgänge 171 bzw. 181 der vorgeschalteten weiteren Speicherelemente 170 bzw. 180 ausgewählt, und damit bilden alle Speicherelemente der in Fig. 9 dargestellten Anordnung ein einziges Schieberegister, das über die Leitung 193 zugeführte Daten seriell durchschiebt und am Ausgang 173 wieder abgibt. Damit kann einerseits geprüft werden, ob alle Speicherelemente funktionsfähig sind, und andererseits können die Speicherelemente 172 bzw. 182 mit bestimmten Daten gefüllt werden, die anschließend über die Treiberstufen 174 bzw. 184 den Busleitungen zugeführt werden können, wenn die Treiberstufen durch ein entsprechendes Signal auf der Leitung 191 und entsprechende Einstellung der weiteren Speicherelemente 170 bzw. 180 niederohmig durchlässig geschaltet werden.

Beim anderen Signal auf der Leitung 199 können die Speicherelemente 172 bzw. 182 das auf den Busleitungen und somit auf den Leitungen 175 bzw. 185 vorhandene Signal übernehmen, wobei diese Signale anschließend, wenn alle Speicherelemente wieder als Schieberegister geschaltet sind, seriell am Ausgang 173 ausgegeben werden können.

## Patentansprüche

1. Integrierte Schaltungsanordnung (100) mit mindestens einer Prüf-Steuerschaltung (110), die über äußere Anschlüsse (102, 101; 52, 54) gesteuert Prüfsteuersignale für die Durchführung der Prüfung der Schaltungsanordnung erzeugt und enthält:
a) ein Schieberegister (20) mit einer Anzahl in Reihe geschalteter Schieberegisterstufen (22, 24, 26, 28, 30) und mit einem seriellen Dateneingang (35) und mit mindestens einem Takteingang (39, 41) für ein Taktsignal zum Weiterschieben der über den Dateneingang (35) zugeführten Datensignale, wobei das Taktsignal von dem Signal eines ersten äußeren Anschlusses (52) abgeleitet ist,
b) je Schieberegisterstufen (22, 24, 26, 28, 30) wenigstens ein Speicherelement (60, 64, 68, 74, 82, 86),
dadurch gekennzeichnet,
daß die integrierte Schaltungsanordnung mehrere digitale Schaltungsblöcke (116, 120, 132, 142) enthält, die prüfbar sind, und daß jede Schieberegisterstufe (22, 24, 26, 28, 30) außer der in der Reihe letzten Schieberegisterstufe (30) wenigstens eine Verknüpfungsstufe (62, 66, 70, 76, 78, 84, 88, 90) enthält, die aus einer logischen Verknüpfung eines Ausgangssignals des Speicherelements bzw. der Speicherelemente dieser Schieberegisterstufe mit einem Ausgangssignal (31) der in der Reihe letzten Schieberegisterstufe (30) und/oder mit einem Eingangssignal eines zweiten äußeren Anschlusses (54) ein Prüfsteuersignal zur Steuerung wenigstens eines der digitalen Schaltungsblöcke (116, 120, 132, 142) erzeugt.

2. Integrierte Schaltungsanordnung nach Anspruch 1 mit wenigstens einem interen Datenbus (112), dadurch gekennzeichnet,
daß für zumindest einige Schaltungsblöcke (116, 120, 132, 142) eine Schaltung (114, 118, 122, 130, 144) vorgesehen ist, über die Dateneingänge und/oder Datenausgänge der Schaltungsblöcke mit dem Datenbus verbunden sind, und daß einige der Prüfsteuersignale die Schaltungen und andere Prüfsteuersignale die Funktion von Schaltungsblöcken steuern.

3. Integrierte Schaltungsanordnung nach Anspruch 1 oder 2, dadurch gekennzeichnet,
daß dem seriellen Dateneingang (35) des Schieberegisters (20) ein Speicherelement (34) vorgeschaltet ist, das bei jedem Übergang in der einen Richtung des Signals am zweiten äußeren Anschluß (54) das Ausgangssignal wechselt.

4. Integrierte Schaltungsanordnung nach Anspruch 1, 2 oder 3,dadurch gekennzeichnet,
daß eine weitere Verknüpfungsschaltung (36) die Signale am ersten und zweiten äußeren Anschluß (52, 54) empfängt und bei einer vorgegebenen Signalkombination ein Rücksetzsignal für alle Speicherelemente des Schieberegisters (20) und weitere Speicherelemente (34) der Prüf-Steuerschaltung erzeugt.

5. Integrierte Schaltungsanordnung nach einem der vorhergehenden Ansprüche, dadurch gekennzeichnet,
daß mindestens eine Schieberegisterstufe zwei in Reihe geschaltete Speicherelemente (82, 86) enthält und daß die nachgeschaltete Verknüpfungsstufe (84, 88, 90) mehrstufig ist und die Ausgangssignale der Speicherelemente (82, 86) getrennt mit den weiteren Signalen verknüpft.

## Claims

1. An integrated circuit arrangement (100), comprising at least one test control circuit (110) which generates, under control via external connections (102, 101; 52, 54), test control signals for the testing of the circuit arrangement, and comprising:
a) a shift register (20) which comprises a number of series-connected shift register stages (22, 24, 26, 28, 30), a serial data input (35) and at least one clock input (39, 41) for a clock signal for transporting the data signals supplied via the data input (35), the clock signal being derived from the signal on a first external connection (52),
b) at least one storage element (60, 64, 68, 74, 82, 86) per shift register stage (22, 24, 26, 28, 30),
characterized in that
the integrated circuit arrangement comprises a plurality of circuit blocks (116, 120, 132, 142) which can be tested, and that each shift register stage (22, 24, 26, 28, 30), with the exception of the last shift register stage (30) in the series, comprises at least one logic stage (62, 66, 70, 76, 78, 84, 88, 90) which generates a test control signal for controlling at least one of the digital circuit blocks (116, 120, 132, 142) from a logic combination of an output signal of the storage element or the storage elements of this shift register stage with an output signal (31) of the last shift register stage (30) in the series and/or with an input signal on a second external connection (54).

2. An integrated circuit arrangement as claimed in Claim 1, comprising at least one internal data bus (112), characterized in that
for at least some circuit blocks (116, 120, 122, 142) there is provided a circuit (114, 118, 122, 130, 144) via which data inputs and/or data outputs of the circuit blocks are connected to the data bus, and that some of the test control signals control the circuits and other test control signals control the function of circuit blocks.

3. An integrated circuit arrangement as claimed in Claim 1 or 2,
characterized in that
the serial data input (35) of the shift register (20) is preceded by a storage element (34) which changes the output signal in response to each transition in the one direction of the\ signal on the second external connection (54).

4. An integrated circuit arrangement as claimed in Claim 1, 2 or 3,
characterized in that
a further logic circuit (36) receives the signals on the first and the second external connection (52, 54) and generates, in response to a predetermined signal combination, a reset signal for all storage elements of the shift register (20) and further storage elements (34) of the test control circuit.

5. An integrated circuit arrangement as claimed in any one of the preceding Claims,
characterized in that
at least one shift register stage comprises two series-connected storage elements (82, 86), and that the succeeding logic stage (84, 88, 90) is a multi-stage type and combines the output signals of the storage elements (82, 86) separately with the further signals.

## Revendications

1. Montage de circuit intégré (100) comportant au moins un circuit de commande de vérification (110) qui produit par l'intermédiaire de connexions externes (102, 101; 52, 54) de manière commandée des signaux de commande de vérification pour l'exécution de la vérification du montage de circuit et qui comprend :
a) un registre à décalage (20) comportant un certain nombre d'étages de registre à décalage (22, 24, 26, 28, 30) montés en série et comportant une entrée de données série (35) et au moins une entrée d'impulsion de synchronisation (39, 41) pour un signal de synchronisation destiné à la progression par décalage des signaux de données appliqués via l'entrée de données (35), le signal de synchronisation étant dérivé du signal d'une première connexion externe (52),
b) pour chaque étage de registre à décalage (22, 24, 26, 28, 30) au moins un élément de stockage (60, 64, 68, 74, 82, 86),
caractérisé en ce que le montage de circuit intégré contient plusieurs blocs de circuit numériques (116, 120, 132, 142) qui peuvent être vérifiés et que chaque étage de registre à décalage (22, 24, 26, 28, 30) contient en dehors du dernier étage de registre à décalage (30) de la série au moins un étage de combinaison logique (62, 66, 70, 76, 78, 84, 88, 90) qui produit à partir d'une combinaison logique d'un signal de sortie de l'élément de stockage ou des éléments de stockage de cet étage de registre à décalage avec un signal de sortie (31) du dernier étage de registre à décalage (30) de la série et/ou avec un signal d'entrée d'une seconde connexion externe (54) un signal de commande de vérification pour la commande d'au moins un des blocs de circuit numérique (116, 120, 132, 142).

2. Montage de circuit intégré suivant la revendication 1 comportant au moins un bus de données interne (112),
caractérisé en ce que, pour au moins quelques blocs de circuit (116, 120, 132, 142), est prévu un circuit (114, 118, 122, 130, 144) par l'intermédiaire duquel les entrées de données et/ou les sorties de données des blocs de circuit sont connectées au bus de données et que quelques-uns des signaux de commande de vérification commandent les circuits, tandis que d'autres signaux de commande de vérification commandent la fonction des blocs de circuit.

3. Montage de circuit intégré suivant la revendication 1 ou 2,
caractérisé en ce que l'entrée de données série (35) du registre à décalage (20) est précédée d'un élément de stockage (34) qui, à chaque transition dans un sens du signal au niveau de la seconde connexion externe (54), modifie le signal de sortie.

4. Montage de circuit intégré suivant la revendication 1, 2 ou 3,
caractérisé en ce qu'un autre circuit de combinaison logique (36) reçoit les signaux de la première et de la deuxième connexions externes (52, 54) et produit, pour une combinaison de signaux prédéterminée, un signal de repositionnement pour tous les éléments de stockage du registre à décalage (20) et pour les autres éléments de stockage (34) du circuit de commande de vérification.

5. Montage de circuit intégré suivant l'une quelconque des revendications précédentes,
caractérisé en ce qu'au moins un étage de registre à décalage contient deux éléments de stockage montés en série (82, 86) et que l'étage de combinaison logique monté en aval (84, 88, 90) présente plusieurs étages et combine les signaux de sortie des éléments de stockage (82, 86) séparément avec les autres signaux.
